# EUROPEAN PATENT APPLICATION

(11) **EP 1 698 936 A2**
(43) Date of publication of application: **06.09.2006**
(21) Application number: 06251062.3
(22) Date of filing: 28.02.2006
(51) Int. Cl.: G03F 7/038

(54) **Negative-type photosensitive resin compositions**

(30) Priority: 01.03.2005 JP 2005056128
(71) Applicant: Rohm and Haas Electronic Materials, L.L.C., Marlborough, Massachusetts 01752 (US)
(72) Inventor: Arao, Kei, Niigata-shi Niigata 950-0074 (JP); Nomura, Makoto, Niigata-shi Niigata, 950-0851 (JP)
(74) Representative: Kent, Venetia Katherine

(57) **Abstract**

Provided are negative-type photosensitive resin compositions which may be used as interlayer insulating layers on a silicon wafer. The compositions include a urea crosslinking agent together with an epoxy-containing material and vinylphenol resin. Also provided are methods of forming patterned insulating layers using such compositions. The resin compositions can be used in the manufacture of wafer-level chip-scale packages and LSIs, for example, as interlayer insulating layers.

## Description

The present invention relates to negative-type photosensitive resin compositions containing a phenol resin and an epoxy-containing material, and to methods of forming patterned insulating layers using the negative-type photosensitive resin compositions.

Conventionally, epoxy resin compositions containing an epoxy resin and a vinylphenol resin have been used as sealing materials for semiconductor devices, such as ICs and LSIs, in view of their reliability as sealing materials. To obtain improved physical properties, a photosensitive resin obtained by adding an epoxy compound to a resin such as a conventional phenol resin has been proposed in manufacturing a wafer level-chip scale package (WL-CSP). Such photosensitive resin compositions, however, exhibit low solubilities in commonly used organic alkaline developers, such as aqueous solutions of tetramethylammonium hydroxide (TMAH). The low solubilities of the resin compositions can create difficulties in the developing process wherein a desired pattern is formed in a layer formed from the composition. Therefore, it is desired to provide photosensitive resin compositions which are capable of retaining desired physical and chemical properties, for example, thermal impact resistance, when used as an interlayer insulating resin or as a resist resin, and which overcome the above-mentioned problem.

Japanese patent publication No. 1993-273753 discloses a photoimageable composition comprising a phenol resin, an epoxy resin, a melamine resin, and a photoacid generator, which may be developed with an aqueous developer. This composition can provide a desired image by exposure to activating radiation and is developed with a solution of an inorganic alkaline such as sodium hydroxide.

Japanese patent publication No. 2004-240213 discloses a photosensitive resin composition prepared by adding biphenyl-phenol resin to a photosensitive resin composition comprising a novolak-containing material and an epoxy-containing material. The photosensitive resin composition purportedly exhibits improved thermal impact resistance, while retaining a photoimageable property. However, this composition should be developed with a solution of an inorganic alkaline, such as potassium hydroxide, and cannot be developed with an organic alkaline solution such as an aqueous TMAH solution, for example, a 2.38 % TMAH aqueous solution such as commonly used in the art.

Japanese patent publication No. 2004-233693 discloses a photosensitive resin composition which may be developed with an aqueous alkaline solution, such as an aqueous TMAH solution to provide a desired pattern. This composition is obtained by adding biphenyl-phenol resin to a photosensitive resin composition comprising a poly(*p*-vinylphenol) and an epoxy-containing material. This photosensitive resin composition purportedly provides an improved photoimageable property as compared to a conventional composition. However, a cured resin obtained by curing the remaining resin after the developing step does not result in the properties desired for an insulating resin with respect to adhesion to a silicon wafer.

Through the invention, the inventors have provided photosensitive resin compositions and methods of forming patterned insulating layers which address one or more problems associated with the state of the art.

In accordance with a first aspect, the present invention provides negative-type photosensitive resin compositions. The compositions include a vinylphenol resin, a biphenyl-phenol resin, an epoxy-containing material, a photoactive component and a urea resin crosslinking agent. A combination of crosslinking agents may be used in the compositions.

In accordance with a second aspect, the present invention provides a method of forming a patterned insulating layer. The method involves: (a) forming a film on a substrate, the forming comprising applying a negative-type photosensitive resin composition to the substrate, wherein the resin composition comprises a vinylphenol resin, a biphenyl-phenol resin, an epoxy-containing material, a photoactive component and a urea resin crosslinking agent; (b) exposing the film; and (c) developing the exposed film to form a patterned insulating layer.

Through the invention, the inventors have found that by use of a urea resin crosslinking agent in the photosensitive resin compositions, such compositions can advantageously be developed in aqueous alkaline solutions such as aqueous TMAH solutions, for example, a 2.38 % TMAH solution and when cured can provide excellent adhesion to a silicon wafer, for example, under PCT conditions (121°C, 100% relative humidity (RH)). Such compositions find particular use, for example, as an interlayer insulating layer in semiconductor devices, such as ICs and LSIs and in WL-CSPs.

The negative-type photosensitive resin compositions of the present invention contain one or more epoxy-containing materials. The epoxy-containing materials useful in the present invention include any organic compounds having one or more, for example, two or more, oxirane rings which are polymerizable by a ring-opening reaction. These materials are commonly known as epoxides, including monomer epoxy compounds, and oligomer or polymer epoxides which may be aliphatic, alicyclic, aromatic, or heterocyclic. The polymer epoxide may include linear polymers having terminal epoxy groups, such as polyoxyalkylene glycol diglycidyl ethers; polymers containing backbone oxirane units, such as polybutadiene polyepoxides; or polymers containing epoxy group(s) in the side chain of the polymer, such as glycidyl methacrylate polymers or copolymers. The epoxide may be a pure compound, but is typically a mixture containing compounds with 1, 2 or more epoxy groups per molecule. Suitable epoxy-containing materials include a low molecular weight monomer material or oligomer, and a high molecular weight polymer. The epoxy-containing materials may have various backbones and various substituents. For example, the backbone may be any type of a polymer chain, and the substituent may be any group which has no substituent capable reaction with an oxirane ring at room temperature. Examples of suitable substituents include halogen atoms, ester groups, ether groups, sulfonate groups, siloxane groups, nitro groups, and phosphate groups.

An epoxy-containing material useful in the present invention is a liquid bisphenol epoxy-containing material. Exemplary liquid bisphenol epoxy containing materials include polyvalent phenol ethers prepared through the reaction of a polyvalent phenol with an excess amount of chlorohydrin (such as epichlorohydrin), for example, diglycidyl ethers of 2,2-bis(2,3-epoxy-propoxyphenol)-propane. A suitable bisphenol epoxy-containing material of the present invention is a bisphenol A epoxy-containing material prepared through the reaction of bisphenol A with epichlorohydrin. The epoxy-containing material of the present invention may be a compound represented by the following general formula (I): 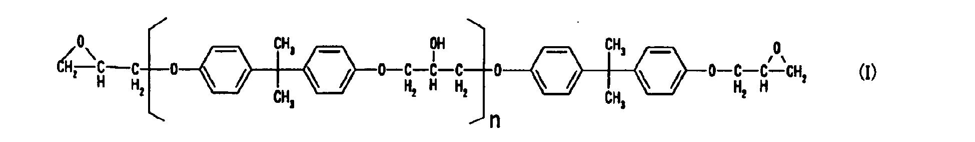 wherein, n = 0 to 2, preferably n = 0 to 1, more preferably n = 0.

Examples of bisphenol epoxy-containing materials include bisphenol A epoxy resins such as EPIKOTE 825, 827, 828, 1001, 1002, etc. (Japan Epoxy Resins Co.), and DER-331, DER-332, and DER-334, etc. (Dow Chemical Co.). Other epoxy compounds useful in the present invention include flexible and tough epoxy resins, aliphatic hydrocarbon epoxy resins, alicyclic hydrocarbon epoxy resins, phenol novolak epoxy resins, cresol novolak resins, biphenyl epoxy resins, and modified epoxy resins thereof. Epoxy resins which are readily available include, for example, bisphenol F epoxy resins, such as EPIKOTE 806, 807, etc. (Japan Epoxy Resins Co.); flexible and tough epoxy resins, such as EPICLON EXA 4850, etc. (Dainippon Ink and Chemicals, Inc.); epichlorohydrin, glycidol, glycidyl methacrylate, *p*-tert-butylphenol glycidyl ether, such as EPI-REZ 5014 (Celanese Co.); dicyclopentadiene diglycidyl ether, such as ADEKA RESIN EP-4088S (Asahi Denka Co.); vinylcyclohexene dioxides, such as ERL-4206 (Union Carbide Corp.); 3,4-epoxy-6-methyl-cyclohexylmethyl-3,4-epoxy-6-methylcyclohexene carboxylate, such as ERL-4201 (Union Carbide Corp.); bis(3,4-epoxy-6-methylcyclohexylmethyl) adipate, such as ERL-4289 (Union Carbide Corp.); bis(2,3-epoxycyclopentyl) ether, such as ERL-0400 (Union Carbide Corp.); polypropylene-glycol-modified aliphatic epoxies, such as ERL-4050 and ERL-4269 (Union Carbide Corp.), dipentene dioxide, such as ERL-4269 (Union Carbide Corp.); nonflammable epoxy resins, such as brominated bisphenyl epoxy resins, such as DER-580 (Dow Chemical Co.); 1,4-butanediol diglycidyl ethers of phenol formaldehyde novolak, such as DEN-431 and DEN-438 (Dow Chemical Co.); and resorcinol diglycidyl ethers, such as Kopoxite (Koppers Company, Inc.).

The negative-type photosensitive resin compositions of the present invention further contain a vinylphenol resin. Typical vinylphenol resins useful in the present invention include poly(*p*-vinylphenol) resins, which are polymers containing *p*-vinylphenol as polymerized units. There is no particular limitation on the polymer as long as it contains no epoxy groups. Typically, the polymer contains 50 % by weight or more of *p*-vinylphenol, based on the total polymerized units of the polymer. More typically, the polymer contains 75 % by weight or more of *p-*vinylphenol, and still more typically, 90 % by weight or more of *p*-vinylphenol. Most typically, the polymer is a *p*-vinylphenol homopolymer, in which the polymerized units of the polymer are all *p*-vinylphenol.

The weight-average molecular weight of the poly(*p*-vinylphenol) is typically 2,000-40,000, and more typically 5,000-35,000.

Poly(*p*-vinylphenol) polymers useful in the present invention may contain polymerized units other than *p*-vinylphenol. Examples of suitable copolymerizable compound include, but are not limited to, esters of acrylic acid or methacrylic acid, such as methyl acrylate, methyl methacrylate, hydroxyethyl acrylate, butyl methacrylate, octyl acrylate, 2-ethoxyethyl methacrylate, *t*-butyl acrylate, 1,5-pentanediol diacrylate, *N,N*-diethylaminoethyl acrylate, ethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, 2,2-di(*p-*hydroxyphenyl)-propane dimethacrylate, triethylene glycol diacrylate, polyoxyethyl-2,2-di(*p-*hydroxyphenyl)-propane dimethacrylate, triethylene glycol dimethacrylate, polyoxypropyl trimethylolpropane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenylethylene-1,2-dimethacrylate, pentaerythritol tetramethacrylate, trimethylolpropane trimethacrylate, 1,5-pentanediol dimethacrylate, and 1,4-benzenediol dimethacrylate; styrene and substituted styrene such as 2-methylstyrene and vinyltoluene; vinyl esters, such as vinyl acrylate and vinyl methacrylate; and o-vinylphenol and m-vinylphenol. The poly(*p*-vinylphenol) can be prepared by methods known in the art. Alternatively, commercially available products, such as MARUKA LYNCUR M S4P (Maruzen Petrochemical Co.), may be used.

The negative-type photosensitive resin compositions of the present invention comprise a biphenyl-phenol resin. As used herein, the biphenyl-phenol resin refers to a polymer including phenol and biphenyl repeating units, which may be polymerized in any order. The polymer may also contain an alkylene structure such as methylene and ethylene units in addition to phenol and biphenyl repeating units. The biphenyl and phenol of the biphenyl-phenol resin may be substituted by a substituent, for example, an alkyl group or an alkoxy group. The biphenyl-phenol resin is free of epoxy groups. The biphenyl-phenol resin can be prepared by methods known in the art. Alternatively, commercially available products, such as Phenol Resin MEH-7851 (Meiwa Kasei Co.), may be used.

Typically, the biphenyl-phenol resin is a resin having a structure represented by following formula (II): 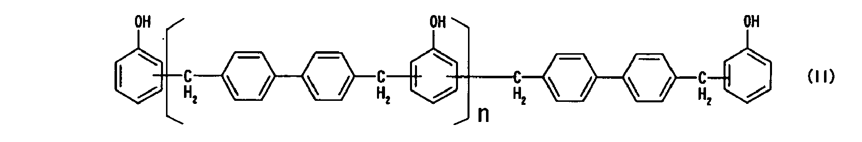 wherein, n = 0-4, typically n = 0-3, and more typically n = 0-1.

The number-average molecular weight of the biphenyl-phenol resin is typically 350-1200, and more typically 370-1000.

In the negative-type photosensitive resin compositions of the present invention, the content of the biphenyl-phenol resin is typically 5-45 % by weight, and more typically 10-40 % by weight, based on the total weight of the vinylphenol resin and the biphenyl-phenol resin.

Optionally, the negative-type photosensitive resin composition of the present invention may contain additional resin binders which do not have an epoxy group, in addition to the above described vinylphenol resin and biphenyl-phenol resin. Such additional resin binders may be any compound capable of bringing about a photoinitiated crosslinking reaction with one or more components in the negative-type photosensitive resin composition.

Examples of suitable resins include, but are not limited to, compounds comprising a functional group having one or more reactive moieties, such as a reactive hydrogen atom, including, for example, phenol/aldehyde condensation polymers (novolak resins), alkenylphenol homopolymers or copolymers, partially hydrogenated novolaks, and *N*-hydroxyphenylmaleimide homopolymers or copolymers.

In the negative-type photosensitive resin compositions of the present invention, the content of such other resin binder is typically 50 % by weight or less, more typically 25 % by weight or less, based on the total weight of the vinylphenol resin, the biphenyl-phenol resin and other resin binders. Most typically, the negative-type photosensitive resin composition of the present invention does not contain such an additional resin binder.

When the negative-type photosensitive resin composition contains a novolak resin as an additional resin binder (wherein the novolak resin does not include a biphenyl-phenol resin), the content of the novolak resin in the composition of the present invention is less than 10 % by weight, typically less than 5 % by weight, based on the total weight of the epoxy-containing material, vinylphenol resin, biphenyl-phenol resin and such additional resin binder. Most typically, the negative-type photosensitive resin composition of the present invention does not contain a novolak resin.

In the negative-type photosensitive resin composition of the present invention, the weight ratio of a mixture of the epoxy-containing materials to the total weight of the vinylphenol resin, the biphenyl-phenol resin and other resin binders ([total weight of the epoxy-containing materials]:[total weight of the vinylphenol resin, the biphenyl-phenol resin and other resin binders]) is typically in the range of 0.5:1 to 2:1, and more typically 0.7:1 to 1.6:1.

The negative-type photosensitive resin compositions of the present invention contain a photoactive component such as a photo-acid-generating agent which can generate an acid on being exposed to an activating radiation. Any photo-acid-generating agent known in the art can be used in the present invention. Typically, the photo-acid-generating agent is an onium salt. The photo-acid-generating agent may be, for example, an onium salt having a weak nucleophilic anion. The anion may be a halogen complex anion of divalent to heptavalent metal or nonmetal, such as Sb, Sn, Fe, Bi, Al, Ga, In, Ti, Zr, Sc, D, Cr, Hf, and Cu as well as B, P, and As. Examples of suitable onium salts include diaryl diazonium salts, and onium salts of group Va, group Vb, group Ia, group Ib, and group I elements in a periodic table, such as halonium salts, for example, iodonium salts typical of which are those formed from aryliodoso tosylate and aryl ketone as described in U.S. Patent No. 4,683,317, aromatic iodonium and iodoxonium salts, quaternary ammonium, phosphonium and arsonium salts, aromatic sulfonium and sulfoxonium or selenonium salts. As the photo-acid-generating agent, onium salts can be prepared by methods known in the art. Alternatively, commercially available products, such as triallylsulfonium hexafluorophosphate, may be used.

The photo-acid-generating agent may be a nonionic organic compound. Typical nonionic organic acid-generating agents include a halogenated nonionic compound, such as 1,1-bis(*p-*chlorophenyl)-2,2,2-trichloroethane (DDT); 1,1-bis(*p*-methoxyphenyl)-2,2,2-trichloroethane) (METHOXYCHLOR); 1,2,5,6,9,10-hexabromocyclododecane; 1,10-dibromodecane; 1,1-bis(*p-*chlorophenyl)-2,2-dichloroethane; 4,4'-dichloro-2-(trichloromethyl)benzhydrol, 1,1-bis(chlorophenyl)-2,2,2-trichloroethanol (KELTHANE); hexachlorodimethylsulfone; 2-chloro-6-(trichloromethyl)pyridine; O,O-diethyl-O-(3,5,6-trichloro-2-pyridyl)phosphorothioate (DURSBAN); 1,2,3,4,5,6-hexachlorocyclohexane; *N*-1,1-bis(*p*-chlorophenyl)-2,2,2-trichloroethylacetamide, tris(2,3-dibromopropyl) isocyanurate; 2,2-bis(*p*-chlorophenyl)-1,1-dichloroethylene; as well as the isomers, analogs and homologues of these compounds. Among the above materials, tris(2,3-dibromopropyl) isocyanurate is typical. Suitable photo-acid-generating agents are also described in European patent publication No. 0232972.

The negative-type photosensitive resin compositions of the present invention contain a sufficient amount of the photo-acid-generating agent to develop the coating film of the composition, after being exposed to activating radiation and optional post-exposure baking.

In addition to the components described above, the negative-type photosensitive resin compositions of the present invention comprise a crosslinking agent. When a urea resin crosslinking agent is used, adhesiveness of the cured resin to a silicon substrate can be improved. The urea resin is typically a glycoluril resin which may have a substituent group. The glycoluril resin can include a tetramethoxy methyl glycoluril resin, such as POWDERLINK 1170, 1171, 1172 and 1174 (CYTEC INDUSTRIES, West Paterson, NJ, USA); or a urea-based resin, such as BEETLE 60, 65, and 80 (CYTEC INDUSTRIES, West Paterson, NJ, USA).

The photosensitive resin compositions of the present invention may further include one or more additional crosslinking agents. Examples of additional crosslinking agents include amine-based materials, such as a melamine crosslinking agents including melamine monomers, melamine oligomers, and melamine polymers; various resins such as melamine-formaldehyde; benzoguanamine crosslinking agents, such as benzoguanamine-formaldehyde resin; and combination thereof. Usually, the melamine-formaldehyde resin is an ether, such as trialkylolmelamine or hexaalkylolmelamine. The alkyl group may contain 1-8 or more carbon atoms, with a methyl group being typical. Depending on the reaction conditions and the concentration of formaldehyde, the methyl ethers may be used to react with each other in order to form more complicated units. Especially suitable amine-based crosslinking agents include CYMEL 300, 301, 303, 350, 370, 380, 1116, and 1130 (for melamine resins, American Cyanamid Company, Wayne, NJ, USA), and CYMEL 1123 and 1125 (for benzoguanamine resins). Other similar amine-based compounds are also commercially available. In the photosensitive resin compositions of the present invention, a combination of a glycoluril resin and a melamine-formaldehyde resin is typical.

In the negative-type photosensitive resin compositions of the present invention, the amount of a crosslinking agent is typically 1-15 % by weight, more typically 2-7 % by weight, based on the total weight of the solid part of the resin composition.

Optionally, the negative-type photosensitive resin composition used in the present invention may contain a photosensitizer. The photosensitizer is added to the composition in a sufficient quantity to increase wavelength photosensitivity. Suitable photosensitizers include, for example, 2-ethyl-9,10-dimethoxyanthracene, 9,10-dichloroanthracene, 9,10-phenylanthracene, 1-chloroanthracene, 2-methylanthracene, 9-methylanthracene, 2-*t*-butylanthracene, anthracene, 1,2-benzanthracene, 1,2,3,4-dibenzanthracene, 1,2,5,6-dibenzanthracene, 1,2,7,8-dibenzanthracene, and 9,10-dimethoxydimethylanthracene, *N*-methylphenothiazine and isopropylthioxanthone. Of these, 2-ethyl-9,10-dimethoxy-anthracene, *N*-methylphenothiazine and isopropylthioxanthone are typical.

Optionally, the negative-type photosensitive resin compositions of the present invention may contain additional additives, including dyes, fillers, wetting agents, flame retardants, leveling agents, and silane coupling agents. When the compositions of the present invention are applied onto a silicon substrate, it is typical that a silane coupling agent is used to improve affinity with the silicon substrate.

The concentrations of the additives, which may be employed in the negative-type photosensitive resin compositions of the present invention, are suitably determined by one skilled in the art depending on materials to be used, applications of the composition, and substrate type. There is no particular limitation on the concentrations of the additives.

The negative-type photosensitive resin compositions of the present invention may also contain a suitable solvent capable of dissolving the components described above. There is no particular limitation on such a solvent, as long as the solvent is able to adequately dissolve the components present in the composition. Any solvent known in the art may be used for this purpose. Suitable solvents include, but are not limited to, one or more glycol ethers such as ethylene glycol monomethyl ether, propylene glycol monomethyl ether, dipropylene glycol monomethyl ether; esters such as methylcellosolve acetate, ethylcellosolve acetate, 1-methoxy-2-propyl acetate, propylene glycol monomethyl ether acetate, dipropylene glycol monomethyl ether acetate; dibasic esters; propylene carbonate; gamma-butyrolactone; and alcohols such as *n-*propanol.

The negative-type photosensitive resin compositions of the present invention may be prepared by dissolving the components described above in the solvent. The solid concentration of these components in the negative-type photosensitive resin composition is suitably determined, depending on various factors such as application process of the resin composition, and components to be used. Generally, the solid concentration may be about 10-70 % by weight or higher, based on the total weight of the negative-type photosensitive resin composition. More particularly, when the resin composition is used for flow coating, the solid concentration may be about 40-50 % by weight or higher, based on the total weight of the composition.

A further aspect of the present invention provides a method of forming a patterned insulating layer. The method involves forming a film on a substrate, the forming comprising applying the negative-type photosensitive resin composition of the invention to the substrate, exposing the film and developing the exposed film to form a patterned insulating layer. The resin composition can be applied onto a substrate by conventional methods including, but not limited to, screen printing, flow coating, roller coating, slot coating, spin coating, curtain coating, static spraying, spray coating, and dip coating, or by applying the composition as a dry film. The viscosity of the photosensitive resin composition can be adjusted to a suitable range by adding a solvent to decrease the viscosity or by adding a thickener or filler to increase the viscosity so that the viscosity of the resin composition meets the requirements of each process. The thickness of the coated film of the resin composition applied to the substrate may be adjusted as desired, and there is no particular limitation on the thickness of the coated film.

As the substrate used in the method of the present invention, a substrate having any shape and any material may be used, as long as the resin pattern can be formed on the substrate. Exemplary materials for the substrate include, but are not limited to, resins, ceramics, metals, glasses and semiconductors. Substrates including a resin material include, for example, printed circuit boards and semiconductor packages. Substrates including a ceramic material include, for example, semiconductor packages. Copper is a typical metal used in the substrate, for example, in copper boards. Suitable glass substrates include, for example, display materials, such as liquid crystal displays (LCDs) and flat panel displays (FPDs). The substrate can be formed by a combination of an insulating material and a conducting material, for example, a substrate with a conducting metal pad on a resin. In addition, a silicon wafer substrate, for example, a silicon wafer having a metal layer such as a sputtered copper film formed thereon may be suitable.

After the coating step, the film may be dried to remove any solvent. If desired, a soft bake step may be carried out by heating to evaporate the solvent from the coated resin composition. The temperature and time are appropriately set in the soft bake step.

In the exposure step, the resin composition film is irradiated with activating radiation. There is no particular limitation for the radiation source used in the exposure step. Typically, radiation in the form of a light beam at 436 nm, 405 nm, 365 nm, and 254 nm from a mercury lamp or at 157 nm, 193 nm, 222 nm, and 248 nm from an excimer laser are suitable for this purpose. The light beam can be monochromatic or polychromatic. Moreover, a phase shift method may also be used in the exposure step. When the resin composition film is irradiated with a patterned activating radiation, the pattern is transferred to the composition film.

After exposure, a post exposure bake (PEB) may be carried out, by methods known in the art under suitable conditions. For example, the post exposure bake (PEB) can be suitably carried out using a hot plate at about 70-140°C for about 15 seconds to 10 minutes. Instead of using a hot plate, a convection oven may be used. In this case, a longer treatment time may be required as compared to the hot plate.

In the developing step, the substrate coated with the resin composition is contacted with a developer. Developers known in the art may be used at a suitable concentration. Suitable developers include, for example, alkaline developers selected from aqueous solutions of inorganic alkaline such as potassium hydroxide, sodium hydroxide, sodium carbonate, potassium carbonate, sodium silicate, sodium metasilicate, aqueous ammonia; primary amines such as ethylamine, *n*-propylamine; secondary amines such as diethylamine, di-*n*-propylamine; tertiary amines such as triethylamine, trimethylamine; and quaternary ammonium salts such as tetramethylammonium hydroxide (TMAH), trimethylhydroxyethyl-ammonium hydroxide. Aqueous TMAH solutions at a concentration of 1-10 % by weight, for example, 2-5 % by weight are typical. The resin compositions of the invention have the advantage in that they can be developed with an aqueous TMAH solution, which is a common developer for photoresists. If desired, the developer may also contain an alcohol, surfactant, and the like. Moreover, it may be beneficial if the resin composition and developer are filtered through a microfilter in order to remove dust before use.

The resin compositions of the present invention can be used not only in manufacturing WL-CSPs and ultra LSIs, but also in fabricating general ICs, masks, printing plates such as planographic plates, engraved plates, and relief printing plates. In addition, the resin compositions can be used as photoresists such as for printed circuit boards, interlayer insulating resins, solder resists, color filters for liquid crystal display devices, photo-hardening inks, paints and adhesives, and can be used in forming or duplicating a relief image. Particularly, the negative-type photosensitive resin compositions of the invention are very useful as interlayer insulating layers for manufacturing WL-CSPs and semiconductor circuits.

The following examples are intended to illustrate further various aspects of the present invention, but are not intended to limit the scope of the invention in any aspect.

### EXAMPLES

### Examples 1-8 and Comparative Example 1

For Examples 1-8 and Comparative Example 1, the negative-type photosensitive resin compositions shown in Table 1 were prepared. Resin patterns were formed and tested for each of the compositions using the Resin Pattern Formation Test described below. The results of the Resin Pattern Formation Test are also set forth in Table 1.

In addition, a test for evaluating adhesion of each of the compositions to a silicon substrate under a PCT condition (121°C, 100% RH) was conducted using the Adhesion Test described below. The results of the Adhesion Test are set forth in Table 2

### Resin Pattern Formation Test

Step 1: The negative-type photosensitive resin composition is applied on a silicon wafer using a spin coater to form a coating film with a dried thickness of 12 micrometers.
Step 2: The substrate coated with the negative-type photosensitive resin composition is heated in a convection oven at 110°C for 30 minutes.
Step 3: The substrate is covered with a quartz mask having a printed chromium pattern, and exposed with UV light generated by a high pressure mercury lamp (including i-line, g-line, and h-line) at a dose of radiation of 1000 mJ/cm² of i-line.
Step 4: The exposed substrate is heated in a convection oven at 70°C for 30 minutes as a post-exposure bake.
Step 5: Development is carried out by dipping the substrate in 2.38 % by weight of an aqueous TMAH solution at 23°C for 2.5 minutes. Formation of the resin pattern is confirmed by visual inspection.

In Table 1, the symbols used for "TMAH development performance" are as follow:
"O" = The photosensitive resin composition film was completely developed.
"Δ" = Only the surface of the photosensitive resin composition film was developed and residual film was observed.
"X" = The photosensitive resin composition film was not developed at all.

The components listed in Table 1 are as follows:
Poly(*p*-vinylphenol) (MARUKA LYNCUR M S4P, Maruzen Petrochemical Co.);
Biphenyl-phenol resin (softening point: 79°C, OH equivalence: 207 g/eq) (Phenol Resin MEH-7851M, Meiwa Kasei Co.);
Bisphenol epoxy-containing material (Bisphenol A epoxy resin, EPIKOTE 828, Japan Epoxy Resin Co., Ltd.);
Crosslinking agent: Tetramethoxymethyl glycoluril (POWDERLINK 1174, MITSUI CYTEC INDUSTRIES);
Crosslinking agent 2: Hexamethoxymethylated melamine (CYMEL303, MITSUI CYTEC INDUSTRIES);
Photo-acid-generating agent: Triallylsulfonium hexafluorophosphate;
Silane coupling agent: γ-glycidoxypropyltrimethoxysilane (TORAY-Dow Corning Silicone Co., Ltd.);
Photosensitizer: 2-ethyl-9,10-dimethoxyanthracene; and
PGMEA: Propylene glycol monomethyl ether acetate.

**Table 1**

| **Component** | **Example No.** | | | | | | | | |
|---|---|---|---|---|---|---|---|---|---|
| | **1** | **2** | **3** | **4** | **5** | **6** | **7** | **8** | **Comp. 1** |
| Poly(*p*-vinylphenol)(g) | 18.1 | 18.1 | 18.1 | 18.1 | 18.1 | 18.1 | 18.1 | 18.1 | 18.1 |
| Biphenyl-phenol resin (g) | 6 | 6 | 6 | 6 | 6 | 6 | 6 | 6 | 6 |
| Bisphenol epoxy-containing material (g) | 27.6 | 27.6 | 27.6 | 27.6 | 27.6 | 27.6 | 27.6 | 27.6 | 27.6 |
| Photo-acid-generating agent (g) | 3.7 | 3.7 | 3.7 | 3.7 | 3.7 | 3.7 | 3.7 | 3.7 | 3.7 |
| Silane coupling agent (g) | 1.2 | 1.2 | 1.2 | 1.2 | 1.2 | 1.2 | 1.2 | 1.2 | 1.2 |
| Photosensitizer (g) | 0.4 | 0.4 | 0.4 | 0.4 | 0.4 | 0.4 | 0.4 | 0.4 | 0.4 |
| Crosslinking agent (g) | 3.4 | 0.2 | 0.3 | 0.7 | 1 | 1.4 | 1.7 | 2 | 0 |
| Crosslinking agent 2 (g) | 0 | 3.2 | 3.1 | 2.7 | 2.4 | 2 | 1.7 | 1.4 | 3.4 |
| PGMEA (g) | 39.4 | 39.4 | 39.4 | 39.4 | 39.4 | 39.4 | 39.4 | 39.4 | 39.4 |
| TMAH development performance | O | O | O | O | O | O | O | O | O |

The photosensitive resin compositions of Examples 1-8 and Comparative Example 1 (Comp. 1) were completely developed by 2.38 % TMAH solution. Also, it was confirmed that the type of crosslinking agent in the photosensitive resin composition did not affect development performance after the exposure step.

### Adhesion test

Step 1: The negative-type photosensitive resin composition is applied on a silicon wafer using a spin coater to form a coating film with a dried thickness of 12 micrometers.
Step 2: The substrate coated with the negative-type photosensitive resin composition is heated in a convection oven at 110°C for 30 minutes.
Step 3: The substrate is exposed with UV light generated by a high pressure mercury lamp (including i-line, g-line, and h-line) at a dose of radiation of 1000 mJ/cm² of i-line. This exposure is carried out without patterning.
Step 4: The exposed substrate is heated in a convection oven at 70°C for 30 minutes as a post-exposure bake.
Step 5: The substrate is heated in a convection oven at 130°C for 30 minutes as a precuring treatment.
Step 6: The substrate is heat-cured in a convection oven at 200°C for the time specified in Table 2.

The results of the adhesion test for the photosensitive resin compositions of Examples 1-8 and Comparative Example 1 are shown in Table 2. The results were obtained using the test according to JIS-K5400, i.e., a cross-cut test of 100 1 mm² grids. The denominator for the "Adhesion" results refers to the total number of 1 mm² grids. The numerator refers to the number of residual grids remaining after a peeling test was performed using tape.

**Table 2**

| **Example No.** | **Heat-cure Time (min.)** | **Adhesion (before PCT)** | **Adhesion (after PCT)** |
|---|---|---|---|
| 1 | 180 | 100/100 | 100/100 |
| 2 | 50 | 100/100 | 90/100 |
| 3 | 50 | 100/100 | 90/100 |
| 4 | 50 | 100/100 | 100/100 |
| 5 | 60 | 100/100 | 100/100 |
| 6 | 60 | 100/100 | 100/100 |
| 7 | 75 | 100/100 | 100/100 |
| 8 | 90 | 100/100 | 100/100 |
| Comp. 1 | 60 | 100/100 | 0/100 |

Before the PCT treatment, Comparative Example 1 showed almost the same level of adhesion as that of Examples 1-8 in accordance with the invention. After the PCT treatment, adhesion for Comparative Example 1 significantly decreased. However, the adhesion for Examples 1-8 was maintained before and after the PCT treatment.

## Claims

1. A negative-type photosensitive resin composition, comprising:
a vinylphenol resin;
a biphenyl-phenol resin;
an epoxy-containing material;
a photoactive component; and
a urea resin crosslinking agent.

2. The negative-type photosensitive resin composition of claim 1, further comprising a melamine crosslinking agent.

3. The negative-type photosensitive resin composition of claim 1, wherein the vinylphenol resin is a poly(vinylphenol) resin.

4. The negative-type photosensitive resin composition of claim 1, wherein the epoxy-containing material is a bisphenol A epoxy-containing material.

5. The negative-type photosensitive resin composition of claim 1, wherein the photoactive component is a photoacid generator.

6. A method of forming a patterned insulating layer, comprising:
(a) forming a film on a substrate, the forming comprising applying a negative-type photosensitive resin composition to the substrate, wherein the resin composition comprises a vinylphenol resin, a biphenyl-phenol resin, an epoxy-containing material, a photoactive component and a urea resin crosslinking agent;
(b) exposing the film; and
(c) developing the exposed film to form a patterned insulating layer.

7. The method of claim 6, wherein the film is developed with an aqueous alkaline solution.

8. The method of claim 6, wherein the resin composition further comprises a melamine crosslinking agent.

9. The method of claim 6, wherein the vinylphenol resin is a poly(vinylphenol) resin.

10. The method of claim 6, wherein the epoxy-containing material is a bisphenol A epoxy-containing material.
